(19)

Europäisches
Patentamt
European
Patent Office
Office européen
des brevets

(11) **EP 2 334 143 A1**

(12) **EUROPEAN PATENT APPLICATION**
published in accordance with Art. 153(4) EPC

(43) Date of publication:
**15.06.2011 Bulletin 2011/24**

(21) Application number: **09816058.3**

(22) Date of filing: **10.09.2009**

(51) Int Cl.:
*H05B 33/02* (2006.01)  *G02B 5/20* (2006.01)
*H01L 51/50* (2006.01)  *H05B 33/12* (2006.01)
*H05B 33/22* (2006.01)

(86) International application number:
**PCT/JP2009/065857**

(87) International publication number:
**WO 2010/035643 (01.04.2010 Gazette 2010/13)**

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**
Designated Extension States:
**AL BA RS**

(30) Priority: **24.09.2008  JP 2008243847**

(71) Applicant: **Sumitomo Chemical Company, Limited
Tokyo 104-8260 (JP)**

(72) Inventor: **GODA, Tadashi
Tsukuba-shi
Ibaraki 305-0821 (JP)**

(74) Representative: **Jackson, Martin Peter
J.A. Kemp & Co.
14 South Square
Gray's Inn
London WC1R 5JJ (GB)**

(54) **SUBSTRATE FOR PATTERN COATING AND ORGANIC EL ELEMENT**

(57)     A substrate for patterned application comprises:
a substrate body having a patterning area (15A) and a
non-patterning area (17A) surrounding the patterning area; a plurality of partitions (15) provided in stripes in the
patterning area of the substrate body; and an ink retaining
portion provided in the non-patterning area on one side
and on the other side of the partitions in their longitudinal
direction and being capable of retaining an applied liquid
ink.

FIG.1

EP 2 334 143 A1

**Description**

TECHNICAL FIELD

The present invention relates to a substrate for patterned application and an organic EL element, a display device, and a color filter, all of which use the substrate for patterned application.

BACKGROUND ART

An organic electroluminescent element (hereinafter, also referred to as an "organic EL element") comprises a pair of electrodes comprising an anode and a cathode and an organic light-emitting layer interposed between the electrodes. When voltage is applied to the organic EL element, while holes are injected from the anode, electrons are injected from the cathode. The injected holes and electrons are recombined in the organic light-emitting layer, and thus, the organic EL element emits light.

The organic light-emitting layer can be formed by, for example, a coating method. Specifically, the organic light-emitting layer can be formed by forming a coating film by a coating method using a liquid ink conprising a material for forming the organic light-emitting layer and by drying the film. Examples of the coating method include an ink-jet printing method by which ink is intermittently dropped to a predetermined position, and a nozzle printing method by which a liquid columnar ink is ejected from a nozzle, and the nozzle is moved to supply the ink continuously.

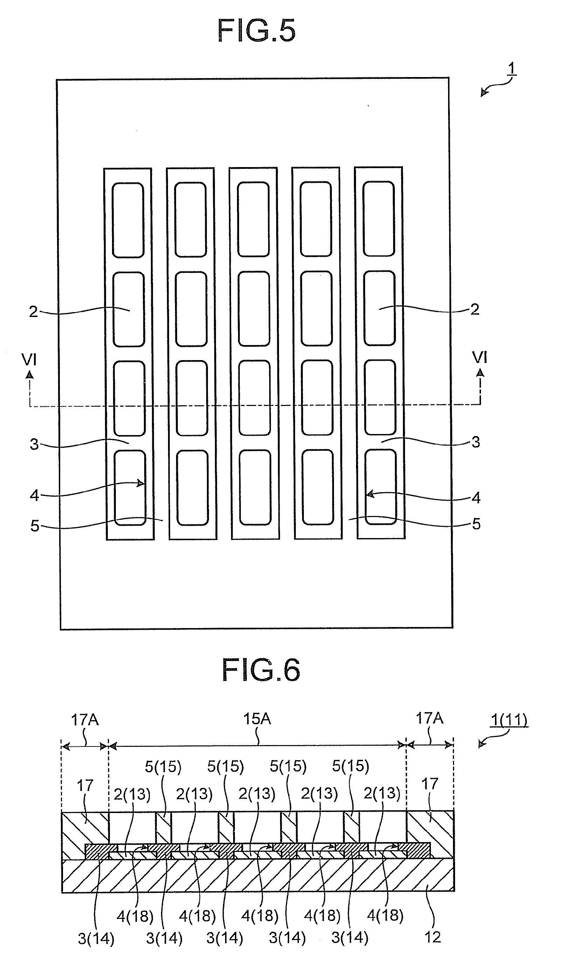

A method for forming an organic light-emitting layer by a nozzle printing method is described below. FIG. 5 is a plane schematic view of a conventional substrate 1 for patterned application used for forming an organic EL element. FIG. 6 is a sectional schematic view of the substrate 1 for patterned application cut along a sectional line VI-VI of FIG. 5.

A plurality of electrodes 2 that extends in stripes is formed on the substrate 1 for patterned application. An insulating film 3 covering the electrodes 2 is formed on the electrodes 2, and a plurality of opening portions 4 through which the surfaces of the electrodes 2 are exposed is hollowly formed in the insulating film 3. The opening portions 4 are hollowly formed at a predetermined interval along each of the electrodes 2. Moreover, a plurality of partitions 5 that is arranged in stripes is formed on the substrate 1 for patterned application. The extending direction of the partitions 5 substantially corresponds to the extending direction of the electrodes 2. Each of the partitions 5 is provided at a position between the neighboring electrodes 2 on the insulating film 3.

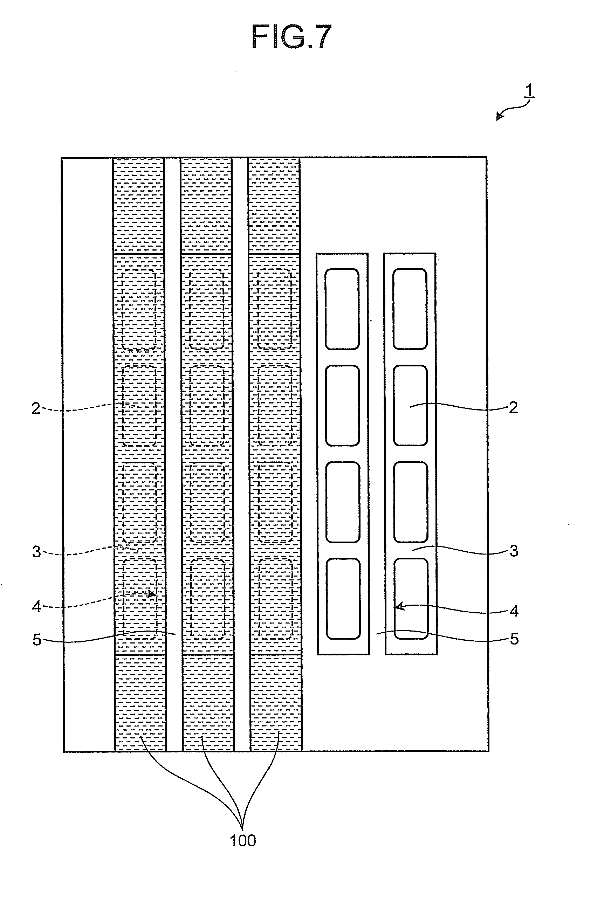

An ink comprising a material for forming the organic light-emitting layer is supplied to the position between the neighboring partitions 5. Specifically, while a liquid columnar ink is ejected from the nozzle of a nozzle printing apparatus, the nozzle positioned above the position between the partitions 5 is moved to either one side of the partitions 5 in the longitudinal direction. Thus, the ink is continuously supplied to the position between the partitions 5 (and to a gap between each of the outermost partitions 5 and an insulating wall positioned further outside of the respective outermost partitions 5). In a nozzle printing method, an ink is applied in a certain continuous line. In other words, the liquid columnar ink is ejected from the nozzle, (1) the nozzle is moved from one side to the other side in the longitudinal direction (in the downward direction in FIG. 5), (2) the nozzle is moved to one side of the partitions 5 in the array direction (in the right direction in FIG. 5), (3) the nozzle is moved from the other side to the one side in the longitudinal direction (in the upward direction in FIG. 5), and (4) the nozzle is moved to one side of the partitions 5 in the array direction (in the right direction in FIG. 5). The ink is supplied to the position between the partitions 5 and to the gap between the partitions 5 and the insulating wall by repeating the processes (1) to (4). In an actual substrate, the partitions 5 may be formed by applying a partition material onto the whole surface of the substrate 1 and then forming opening portions in stripes. Therefore, the partition material may remain at not only the partitions 5 but also the bottom portions. FIG. 7 illustrates a state immediately after the ink is supplied into the left three lines of a plurality of concave portions that is formed with the partitions 5 and the bottom portions.

As described above, a coating film is formed by supplying an ink and then is dried to form an organic light-emitting layer (see Patent Document 1, for example).

Patent Document

Patent Document 1: JP 2002-75640 A

DISCLOSURE OF INVENTION

PROBLEM TO BE SOLVED BY THE INVENTION

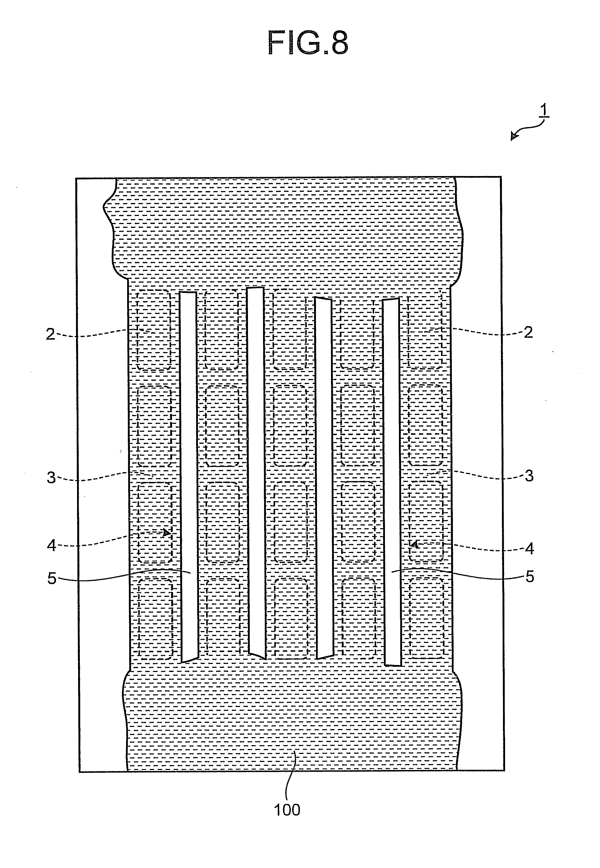

FIG. 8 is a plane schematic view of the conventional substrate 1 for patterned application to which an ink 100 is supplied by a nozzle printing method. By the nozzle printing method, the ink 100 is supplied in a certain continuous line without stopping the ejection of the ink, and therefore, the ink 100 is supplied to an area other than an area to which the ink 100 needs to be supplied. Specifically, in FIGS. 7 and 8, the ink 100 that is unnecessary for an organic EL element is supplied to one end and the other end of the substrate 1 for patterned application in the longitudinal direction. The ink 100 in neighboring lines is separated from each other by the partitions 5 in an area where the partitions 5 are formed, and therefore, the ink 100 in the neighboring lines does not come in contact with each other. However, in an area where the partitions 5 are not provided, the applied ink 100 wets and spreads over the area, and therefore, the ink 100 in neighboring lines may come in contact with each other, and the applied ink 100 may flow into the concave portion between the partitions 5. When the ink 100 applied to the area where the partitions 5 are not provided flows into the concave portion between the partitions 5, the film thickness of the ink at both ends in the longitudinal direction becomes large, and thus, an organic light-emitting layer having a uniform film thickness cannot be formed. Moreover, when the ink 100 in different types (for example, inks with different light-emitting colors) is applied to neighboring lines, color mixing occurs.

Accordingly, an object of the present invention is to provide a substrate for patterned application with which when an ink is selectively supplied by an applying method, the supplied ink can be prevented from mixing with each other at the outside of an area where partitions are formed. Moreover, the substrate for patterned application can prevent the ink supplied to the outside of the area where the partitions are formed from flowing into the area where the partitions are formed.

MEANS FOR SOLVING PROBLEM

The present invention provides the following:

[1] A substrate for patterned application comprising:

a substrate body having a patterning area and a non-patterning area surrounding the patterning area;
a plurality of partitions provided in stripes in the patterning area of the substrate body; and
an ink retaining portion provided in the non-patterning area on one side and on the other side of the partitions in their longitudinal direction and being capable of retaining an applied liquid ink.

[2] The substrate according to above [1] for patterned application, wherein the ink retaining portion is a lyophilic portion having such a lyophilicity that a contact angle to anisole is less than 30 degrees.
[3] The substrate according to above [2] for patterned application,
wherein the ink retaining portion comprises an inorganic substance.
[4] The substrate according to above [3] for patterned application,
wherein the lyophilic portion comprises silicon oxide, silicon nitride, or a mixture thereof.
[5] The substrate according to any one of above [2] to [4] for patterned application, further comprising a masking tape interposed between the substrate body and the lyophilic portion,
wherein the lyophilic portion is provided in contact with the masking tape.
[6] The substrate according to above [1] for patterned application,
wherein the ink retaining portion is an absorption portion that has anisole absorptivity.
[7] The substrate according to above [6] for patterned application,
wherein the absorption portion is porous.
[8] The substrate according to above [6] or [7] for patterned application,
wherein the absorption portion comprises silicon oxide, silicon nitride, a macromolecular compound, or a mixture thereof.
[9] The substrate according to any one of above [6] to [8] for patterned application, further comprising a masking tape interposed between the substrate body and the absorption portion,
wherein the absorption portion is provided in contact with the masking tape.
[10] An organic electroluminescent element manufactured by using the substrate according to any one of above [1] to [9] for patterned application.
[11] A display device comprising the organic electroluminescent element according to above [10].
[12] A color filter manufactured by using the substrate according to any one of [1] to [9] for patterned application.

EFFECT OF THE INVENTION

According to the present invention, when an ink is selectively supplied by a coating method, the supplied ink can be prevented from mixing with each other at the outside of an area where partitions are formed, and also the ink supplied to the outside of the area where the partitions are formed can be prevented from flowing into the area where the partitions are formed.

BRIEF DESCRIPTION OF DRAWINGS

FIG. 1 is a plane schematic view of a substrate for patterned application of an embodiment of the present invention.
FIG. 2 is a sectional schematic view of the substrate for patterned application cut along a sectional line II-II of FIG. 1.
FIG. 3 is a plane schematic view of the substrate for patterned application that is coated with an ink.
FIG. 4 is a sectional schematic view of a substrate for patterned application for color filters.
FIG. 5 is a plane schematic view of a conventional substrate for patterned application used for forming an organic EL element.
FIG. 6 is a sectional schematic view of the conventional substrate for patterned application cut along a sectional line VI-VI of FIG. 5.
FIG. 7 is a schematic view illustrating a state immediately after the ink is supplied into the left three lines of a plurality of concave portions that are formed on the conventional substrate for patterned application.
FIG. 8 is a plane schematic view of the conventional substrate for patterned application to which the ink is supplied by a nozzle printing method.

BEST MODE(S) FOR CARRYING OUT THE INVENTION

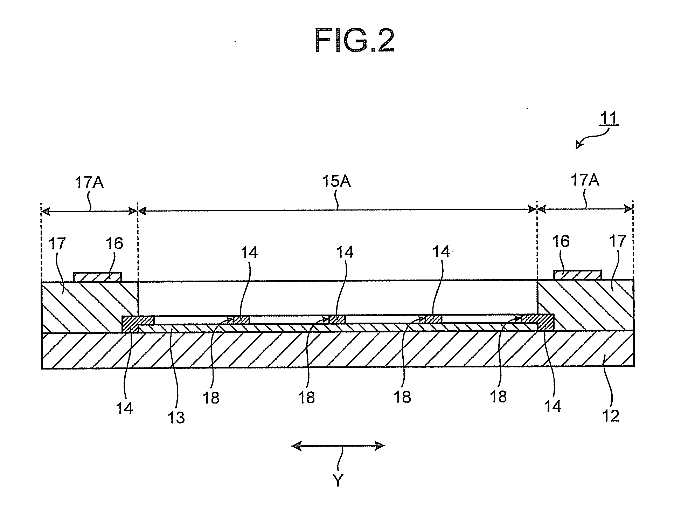

Embodiments of the present invention are described below with reference to the accompanying drawings. Each of the drawings simply schematically illustrates the shape, the size, and the arrangement of components to an extent necessary for understanding the present invention. The present invention is not limited to the descriptions below, and various changes and modifications can be made on each of the components without departing from the spirit and scope of the present invention. In each of the drawings used for the descriptions below, identical numerals are given to the same or similar components, and overlapping descriptions may be omitted. Examples described below are described with reference to the drawings in which a substrate is arranged at the bottom in principle for convenience of descriptions of layer structures and the like. However, a substrate for patterned application, an organic EL element, and the like of the present invention are not necessarily manufactured, used, or the like in the illustrated arrangement.

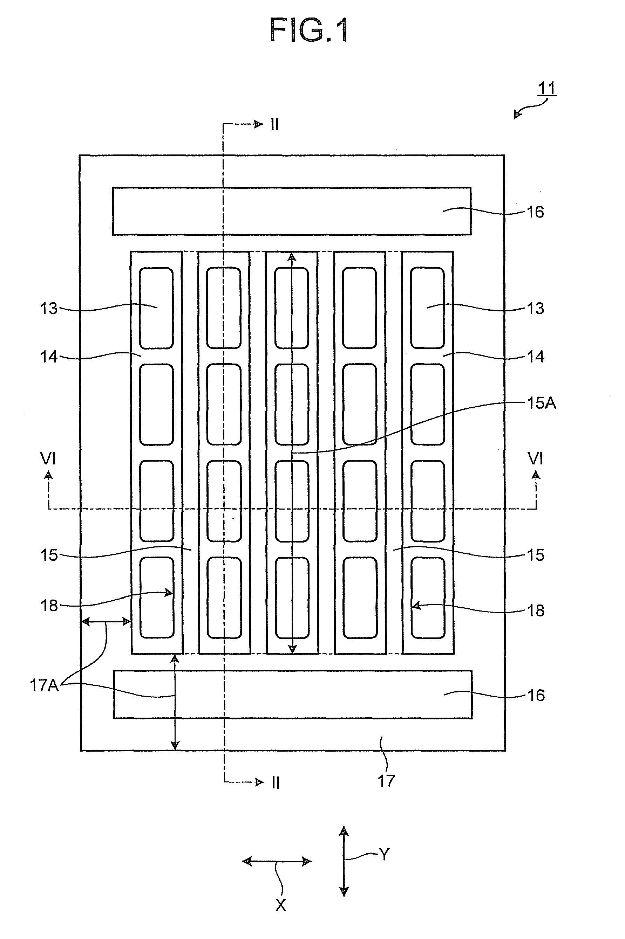

FIG. 1 illustrates a substrate 11 for patterned application of an embodiment of the present invention. In the present embodiment, an example of substrate used for forming an organic EL element is described.
The substrate 11 for patterned application of the present embodiment comprises a substrate body having a patterning area 15A and a non-patterning area 17A surrounding the patterning area 15A, a plurality of partitions provided in stripes in the substrate body , and ink retaining portions provided in the non-patterning area 17A on one side and on the other side of the partitions in the longitudinal direction and being capable of retain an applied liquid ink.
The present embodiment describes a structural example in which the ink retaining portions are lyophilic portions 16 that have a contact angle to anisole of less than 30 degrees and has lyophilicity.
The structural example is described with reference to FIG. 6 because the sectional schematic view cut along a sectional line VI-VI of FIG. 1 is similar to that of FIG. 6 as described above except for the reference numerals. FIG. 2 is a sectional schematic view of the substrate 11 for patterned application cut along a sectional line II-II of FIG. 1.
The substrate 11 for patterned application of the present embodiment comprises a substrate body 12, a plurality of electrodes 13, an insulating film 14, a partition 15, and the lyophilic portions 16.
The electrodes 13 are arranged on the surface of the substrate body 12 in stripes. In other words, the electrodes 13 are approximately parallelly arranged so as to face each other. Each of the electrodes 13 may not necessarily be linear, may be in a wavy line shape, or may be provided so as to have a large width and a small width. The electrode 13 functions as one of a pair of electrodes of an organic EL element that will be described later, for example, functions as an anode of an organic EL element.
The insulating film 14 having electrical insulating properties is formed on the substrate body 12 on which the electrodes 13 are formed. A plurality of opening portions 18 is hollowly formed in the insulating film 14 on each of the electrodes 13 at a predetermined interval along the longitudinal direction (a Y direction) of the electrode 13. The opening portions 18 are hollowly formed through the insulating film 14, and the surface of the electrode 13 is exposed through the opening portions 18. The opening portions 18 are arranged in a matrix as viewed from one side of a thickness direction Z of the substrate body 12. In other words, the insulating film 14 is provided in a grid. An organic EL element that independently emits light as a so-called pixel is formed in an area where each of the opening portions 18 is formed. The insulating film 14 is provided as needed, and a substrate for patterned application having no insulating film 14 may also be structured.
The partition 15 arranged in plurality in stripes is provided onto the insulating film 14. Specifically, the partitions 15 are approximately parallelly provided so as to face each other so that the longitudinal direction of the partitions 15 substantially corresponds to the longitudinal direction of the electrodes 13. The longitudinal direction of the partitions 15 may be called the longitudinal direction Y, and a direction where the partitions 15 are arrayed may be called an array direction X, hereinafter. Moreover, in the present embodiment, a frame-shaped insulating wall 17 is provided on the substrate body 12. The partitions 15 are formed within the frame of the frame-shaped insulating wall 17. One end and the other end of the partitions 15 in the longitudinal direction Y are made in connection with the insulating wall 17, and the partitions 15 and the insulating wall 17 are integrally formed. The insulating wall 17 is formed in a frame shape having two linear portions extending in the array direction X and two linear portions extending in the longitudinal direction Y. Surface portions of the two linear portions extending in the longitudinal direction Y that face the inside of the frame function as partitions provided at the outermost positions of the insulating wall 17 provided in plurality. The insulating wall 17 is provided as needed, and a substrate for patterned application having no insulating wall may also be structured.

An area excluding the patterning area 15A is called the non-patterning area 17A (an area where the frame-shaped insulating wall 17 is provided) relative to the patterning area 15A where the partitions 15 are provided. The lyophilic portions 16 are provided at the non-patterning area 17A, and specifically, are provided near one side and the other side of the patterning area 15A in the longitudinal direction Y. The patterning area where the partitions 15 are provided is an area that comprises an area where the partitions 15 themselves are provided, is an area to which an ink that will be described later is supplied, and specifically, is an area surrounded by the partitions 15 arranged at the outermost positions among the partitions 15 arranged in stripes. In the present embodiment, an area surrounded by the frame-shaped insulating wall 17 correspondences to the patterning area 15A.

The lyophilic portions 16 may be provided at the whole area of the non-patterning area or may be provided at the whole area of the non-patterning area near one side and the other side of the partitions in the longitudinal direction in the patterning area. In the present embodiment, the lyophilic portions 16 are provided as two spaced portions at a part of the whole area of the non-patterning area 17A near one side and the other side of the partitions in the longitudinal direction in the patterning area (near both ends of the partitions 15 in stripes in the extending direction thereof). Specifically, the lyophilic portions 16 are provided at areas in the non-patterning area 17A to which the ink is applied by at least a nozzle printing method described later. The areas position between one end of the patterning area 15A in the longitudinal direction Y and one end of the substrate in the longitudinal direction Y and between the other end of the patterning area 15A in the longitudinal direction Y and the other end of the substrate in the longitudinal direction Y. In the present embodiment, the lyophilic portions 16 are arranged at areas near one side and the other side of the partitions in the longitudinal direction Y in the patterning area 15A so as to extend along the patterning area 15A in the array direction X and are arranged so as to be wider than at least the patterning area 15A in the array direction X. The lyophilic portions 16 are provided on the surfaces of the two linear portions of the frame-shaped insulating wall 17 that extends in the array direction X as described above. The surface of each of the lyophilic portions 16 has such lyophilicity that the contact angle to anisole is less than 30 degrees. At least the contact angle of the lyophilic portion 16 to anisole is smaller than the contact angle of the insulating wall 17 to anisole. A solvent that dissolves a material for forming a predetermined organic layer is not limited to anisole. When the solvent has such lyophilicity that the contact angle to anisole is less than 30 degrees, the solvent has lyophilicity also to an ink generally used, and therefore, the lyophilic portion 16 has lyophilicity as compared with the insulating wall 17. At least, the contact angle of the surface of the lyophilic portion 16 to anisole is smaller than the contact angle of the surfaces of a plurality of concave portions defined by the partitions 15 and the substrate body 12 to anisole. The surfaces of the concave portions mean the surfaces of the partitions 15, the insulating film 14, and the electrodes 13. When predetermined organic layers are formed at positions between the partitions 15, the surfaces of the concave portions mean the surfaces of the partitions 15, the insulating film 14, and the organic layers (not illustrated). In other words, the lyophilic portion 16 has lyophilicity as compared with the surfaces of the concave portions. The lyophilicity of the surfaces of the concave portions are obtained by averaging the lyophilicity of each member constituting the surfaces of the concave portions.

A method for manufacturing the substrate 11 for patterned application is described below.

The substrate body 12 is prepared. A conductive film is formed on the whole surface of the substrate using a material for electrodes that will be described later by, for example, a sputtering method. The conductive film is patterned into stripes by a photolithography method (hereinafter, the photolithography method may comprise a patterning process such as an etching process) to form the electrodes 13 in stripes.

Subsequently, the insulating film 14 is formed. The insulating film 14 is made of inorganic substances or organic substances.

Examples of the inorganic substances constituting the insulating film 14 include $SiO_2$ and SiN. An inorganic insulating material is deposited on the whole surface of the substrate by a known method such as a plasma chemical vapor deposition (CVD) method and a sputtering method. A thin film made of the inorganic substances thus deposited is patterned into a predetermined shape by a photolithography method to form the insulating film 14. During the patterning, the opening portions 18 described above are hollowly formed. The width of the opening portion 18 in the array direction X and the width of the opening portion 18 in the longitudinal direction Y are set according to the resolution. The width in the array direction X is generally 30 micrometers to 200 micrometers, the width in the longitudinal direction Y is generally 100 micrometers to 500 micrometers, and the widths are set as appropriate according to definition of a display to be manufactured.

The insulating film 14 made of organic substances may be formed using a positive or negative photosensitive material (photoresist) of acrylic resins, novolac resins, or polyimide resins. Specifically, the insulating film 14 patterned in a predetermined shape can be produced by applying a photoresist onto the substrate, radiating light to the predetermined area through a predetermined mask to develop the photoresist. During the patterning, the opening portions 18 described above are hollowly formed. The method for applying a photoresist may be a method using a spin coater, a bar coater, a roll coater, a die coater, a gravure coater, a slit coater, or the like.

The insulating film 14 having a grid shape as viewed from one side of a thickness direction thereof is formed on the substrate body 12 by such patterning. The insulating film 14 is provided in order to insulate a plurality of pixels from each other that is arranged in the longitudinal direction Y. The film thickness of the insulating film 14 is set to a thickness capable of ensuring insulation between the pixels arranged in the longitudinal direction Y, and is generally, 0.1 micrometer to 1 micrometer, and preferably, 0.2 micrometer to 0.4 micrometer. The insulating film 14 may not be provided depending on the value of the electric resistance of an organic material that will be described later.

Subsequently, the partitions 15 and the insulating wall 17 are formed. Specifically, the partitions 15 and the insulating wall 17 are formed by, for example, applying the photoresist described above to the whole surface of the substrate, radiating light to the predetermined area through a predetermined mask to develop the photoresist. In the present embodiment, during the development, the opening portions 18 extending in the longitudinal direction Y are hollowly formed in the layer made of the photoresist, and thus, the partitions 15 and the insulating wall 17 are formed. The photoresist can be applied by a method using a spin coater, a bar coater, a roll coater, a die coater, a gravure coater, a slit coater, or the like. As another embodiment, a portion corresponding to the insulating wall 17 may be removed while the opening portions 18 are hollowly formed in the layer made of the photoresist. The partitions 15 are provided in order to insulate pixels from each other that are separated by the partitions 15 and that neighbor each other in the array direction X and to prevent color mixing of the ink constituting the pixels neighboring in the array direction X. Specifically, the partitions 15 are provided in order to prevent the ink from flowing over the partition 15 into the concave portions neighboring each other in the array direction X while the ink is supplied to the concave portions. The height of the partition 15 is set based on this viewpoint and is generally, 0.5 micrometer to 1.5 micrometers, and preferably, 0.5 micrometer to 1.0 micrometer. A width of the partition 15 in the array direction X is set according to the resolution and is generally, 5 micrometers to 50 micrometers, and preferably, 5 micrometers to 20 micrometers. The spacing between the neighboring partitions 15 is set according to the resolution, is generally, 40 micrometers to 220 micrometers, and is set as appropriate according to definition of a display to be manufactured.

Generally, the partitions 15 preferably have hydrophobicity in order to contain the ink supplied between the partitions 15 in the position between the partitions 15. The surface of an organic substance is fluorinated by performing a plasma treatment in a fluorine containing atmosphere and is hydrophobized. Therefore, a method for imparting hydrophobicity to the partitions 15 made of an organic substance may be a method for performing a plasma treatment in a fluorine containing atmosphere after the partitions 15 are formed. Specifically, the surfaces of the partitions 15 can be hydrophobized by performing a $CF_4$ plasma treatment. Hydrophobicity may be imparted to the partitions 15 by a method different from the method as described above, or the partitions 15 made of an inorganic substance may be formed, and then, the surfaces of the partitions 15 may be coated with a material having hydrophobicity. When the insulating film 14 is made of an organic substance, the insulating film 14 is also hydrophobized together by performing a plasma treatment in a fluorine containing atmosphere.

The lyophilic portion 16 preferably comprises an inorganic substance. The inorganic substance constituting the lyophilic portion 16 preferably comprises silicon oxide, silicon nitride, or a mixture thereof.

Although the organic substance is hydrophobized by performing a $CF_4$ plasma treatment as described above, the inorganic substance maintains the lyophilicity even when subjected to a $CF_4$ plasma treatment. Accordingly, when the lyophilic portion 16 comprises an inorganic substance, the lyophilic portion 16 ensures the lyophilicity, for example, even when the partitions 15 are made to be lyophilic by a $CF_4$ plasma treatment after the lyophilic portion 16 is formed on the substrate body 12. Therefore, there is no need to consider the order of processes for forming the lyophilic portion 16, which increases flexibility in the processes. For example, a $CF_4$ plasma treatment may be performed immediately before the formation of an organic light-emitting layer. When the lyophilic portion 16 comprises an inorganic material, the lyophilic portion 16 can be formed in advance because the lyophilic portion 16 ensures the lyophilicity even after the $CF_4$ plasma treatment.

The lyophilic portion 16 can be directly provided on the insulating wall 17 by a CVD method or a sputtering method. The lyophilic portion 16 may also be provided to the non-patterning area by providing the lyophilic portion onto the substrate 12 in advance, forming the insulating wall 17 thereon, and forming an opening in the insulating wall 17 to expose the lyophilic portion on the substrate 12.

The lyophilic portion 16 is preferably formed on a masking tape. Specifically, the substrate 11 for patterned application further comprises a masking tape interposed between the substrate body 12 and the lyophilic portion 16. The lyophilic portion 16 is provided in contact with one surface of the masking tape. A binder is provided on the other surface of the masking tape that is opposite to the surface to which the lyophilic portion 16 is provided. Therefore, the masking tape can be attached to the insulating wall 17 with the binder and can be peeled from the insulating wall 17 after the attachment. In the present embodiment, the masking tape whose surface is formed with the lyophilic portion 16 is attached to the non-patterning area 17A.

The lyophilic portion 16 can be formed on the surface of the masking tape by, for example, a CVD method and a sputtering method. When the lyophilic portion 16 is formed on the masking tape in such a manner, the lyophilic portion 16 can be easily attached via the masking tape and can be easily peeled off to improve the workability.

A method for manufacturing an organic EL element using the substrate 11 for patterned application described above will be described.

An organic EL element comprises at least an organic light-emitting layer between a pair of electrodes as described later. Hereinafter, an organic EL element in which the organic light-emitting layer is provided directly in contact with the electrodes is described.

A method of forming an organic light-emitting layer by a coating method using a nozzle printing apparatus will be described in the present embodiment. As the nozzle printing apparatus, a commercial nozzle printing apparatus is available, for example, NP-300G manufactured by DAINIPPON SCREEN MFG. CO., LTD. is available.

The nozzle printing apparatus supplies an ink comprising a material for forming the organic light-emitting layer to a position between the neighboring partitions 15. The ink comprises a light-emitting material and a solvent both of which are described later.

The nozzle printing apparatus ejects a liquid columnar ink from the nozzle and making the nozzle positioned above a position between the partitions 15 move to one side in the longitudinal direction to supply the ink to the position between the partitions 15. In a nozzle printing method, an ink is applied in a certain continuous line. In other words, the liquid columnar ink is ejected from the nozzle, (1) the nozzle is moved from one side to the other side in the longitudinal direction Y (in the downward direction in FIG. 1), (2) the nozzle is moved to one side of the partitions 15 in the array direction X (in the right direction in FIG. 1), (3) the nozzle is moved from the other side to the one side in the longitudinal direction (in the upward direction in FIG. 1), and (4) the nozzle is moved to one side of the partitions 15 in the array direction X (in the right direction in FIG. 1). The ink is supplied to the position between the partitions 15 and to a gap between each of the outermost partitions 5 and an insulating wall 17 positioned further outside of the respective outermost partitions 5 by repeating the processes (1) to (4).

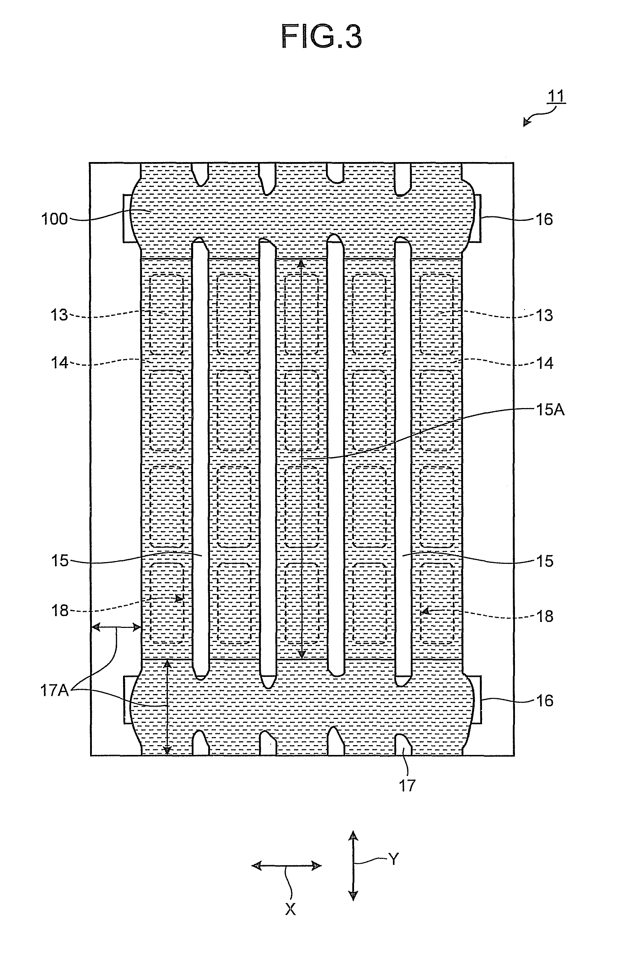

FIG. 3 is a plane schematic view of the substrate 11 for patterned application that is applied with an ink 100. In the nozzle printing method, the ink 100 is continuously applied in a certain continuous line without stopping the ejection of the ink 100, and therefore, the ink 100 is applied also onto the lyophilic portion 16. The lyophilic portion 16 has a small contact angle to the liquid ink 100 and has lyophilicity, and thus, the ink applied onto the lyophilic portion 16 wets and spreads over the lyophilic portion 16 and is retained on the lyophilic portion 16. Accordingly, the ink applied to the non-patterning area 17A where the patterning area 15A is not provided can be prevented from flowing into the position between the partitions 15 and into the gap between each of the outermost partitions 5 and the insulating wall positioned further outside of the respective outermost partitions 5, both of which are the patterning area 15A.

As a result, the ink can be prevented from being mixed with the ink applied to the neighboring lines. Therefore, the film thickness at both ends of the patterning area 15A in the longitudinal direction can be prevented from being thicker than the film thickness at the center when the supplied ink is dried, and thus, an organic light-emitting layer having a uniform film thickness can be formed in the patterning area 15A.

In terms of preventing the ink retained in the lyophilic portion 16 from returning to (flowing into) the patterning area 15A, a space is preferably provided between the lyophilic portion 16 and the patterning area 15A, and the size of the space is preferably 500 micrometers to 5000 micrometers.

Although color mixing of the ink is not caused in a display panel for a monochrome display device, color mixing of the ink becomes a serious problem in, for example, a display panel for a color display device. For example, an R light-emitting material that emits red light, a G light-emitting material that emits green light, and a B light-emitting material that emits blue light need to be separately applied to a display panel for a color display device. Specifically, three types of inks comprising the light-emitting materials need to be separately applied by lines, for example, an ink comprising the R light-emitting material, an ink comprising the G light-emitting material, and an ink comprising the B light-emitting material are individually applied into the concave portions at an interval of two lines. Thus, the three types of the inks can be separately applied. In a nozzle printing method, each type of the inks is applied into the concave portions at an interval of two lines in a continuous line as described above. When a conventional substrate to which the lyophilic portion 16 is not provided is used, the three types of the inks are mixed in the non-patterning area 17A and spread out or flow into the patterning area 15A in the mixed state to cause color mixing. However, the lyophilic portion 16 is provided in the present embodiment, and thus, the inks applied to the outside of the patterning area 15A wet and spread over the lyophilic portion 16. Therefore, even when color mixing of the inks is caused on the lyophilic portion 16, the inks can be prevented from flowing into the patterning area 15A, which can prevent the color mixing in the patterning area 15A.

After the inks are applied, an organic light-emitting layer can be formed by drying at a predetermined temperature and a time condition in atmosphere such as an air atmosphere, an inert gas atmosphere, and a vacuum atmosphere.

After the organic light-emitting layer is formed, for example, the other electrodes are formed. The present embodiment describes a passive matrix organic EL element. In the present embodiment, a plurality of the other electrodes extending in the array direction X is arranged at a predetermined interval in the longitudinal direction Y. Specifically, the other electrodes are arranged so that the electrodes 13 and the other electrodes are overlapped at positions where the opening portions 18 are formed as viewed from one side of the substrate body 12 in the thickness direction.

One of the pair of the electrodes is an anode and the other is a cathode. Organic EL elements provided to predetermined pixels can selectively emit light by providing the pair of the electrodes in such an arrangement.

Although the embodiment in which the organic light-emitting layer is singly provided between the pair of the electrodes is described above, a layer different from the organic light-emitting layer can be provided between the pair of the electrodes.

The layer provided between the cathode and the light-emitting layer may be an electron injection layer, an electron transport layer, and a hole block layer. When both of the electron injection layer and the electron transport layer are provided between the cathode and the light-emitting layer, a layer making contact with the cathode is called the electron injection layer, and the layer except for the electron injection layer is called the electron transport layer.

The electron injection layer is a layer having function to improve electron injection efficiency from the cathode. The electron transport layer is a layer having function to improve electron injection from the cathode, the electron injection layer, or the electron transport layer closer to the cathode. The hole block layer is a layer having function to block the transport of holes. When any one of the electron injection layer and the electron transport layer or both has function to block the transport of holes, the layer may also serve as the hole block layer.

The function of the hole block layer to block the transport of holes can be confirmed by, for example, manufacturing an element in which only hole current flows and confirming an effect of blocking holes through the reduction of the current value.

The layer provided between the anode and the light-emitting layer may be a hole injection layer, a hole transport layer, and an electron block layer. When a single layer is provided between the anode and the light-emitting layer, the layer is called the hole injection layer. When both of the hole injection layer and the hole transport layer are provided between the anode and the light-emitting layer, a layer making contact with the anode is called the hole injection layer, and the layer except for the hole injection layer is called the hole transport layer.

The hole injection layer is a layer having function to improve hole injection efficiency from the anode. The hole transport layer is a layer having function to improve hole injection from the anode, the hole injection layer, or the hole transport layer closer to the anode. The electron block layer is a layer having function to block the transport of electrons. When any one of the hole injection layer and the hole transport layer or both has function to block the transport of electrons, the layer may also serve as the electron block layer.

The function of the electron block layer to block the transport of electrons can be confirmed by, for example, manufacturing an element in which only electron current flows and confirming an effect of blocking electrons through the reduction of the current value.

The electron injection layer and the hole injection layer may be collectively called charge injection layers, and the electron transport layer and the hole transport layer may be collectively called charge transport layers.

Examples of Layer structures applicable to the organic EL element are described below.

  a) anode/light-emitting layer/cathode
  b) anode/hole injection layer/light-emitting layer/cathode
  c) anode/hole injection layer/light-emitting layer/electron injection layer/cathode
  d) anode/hole injection layer/light-emitting layer/electron transport layer/cathode
  e) anode/hole injection layer/light-emitting layer/electron transport layer/electron injection layer/cathode
  f) anode/hole transport layer/light-emitting layer/cathode
  g) anode/hole transport layer/light-emitting layer/electron injection layer/cathode
  h) anode/hole transport layer/light-emitting layer/electron transport layer/cathode
  i) anode/hole transport layer/light-emitting layer/electron transport layer/electron injection layer/cathode
  j) anode/hole injection layer/hole transport layer/light-emitting layer/cathode
  k) anode/hole injection layer/hole transport layer/light-emitting layer/electron injection layer/cathode
  l) anode/hole injection layer/hole transport layer/light-emitting layer/electron transport layer/cathode
  m) anode/hole injection layer/hole transport layer/light-emitting layer/electron transport layer/electron injection layer/ cathode
  n) anode/light-emitting layer/electron injection layer/cathode
  o) anode/light-emitting layer/electron transport layer/cathode

p) anode/light-emitting layer/electron transport layer/electron injection layer/cathode

(Where a symbol "forward slash (/)" indicates that the layers crossing the symbol "/" are adjacently stacked. The same shall apply hereinafter.)

The organic EL element of the present embodiment may comprise two or more light-emitting layers. The organic EL element having two light-emitting layers may be a layer structure of q) below where a layered body interposed between an anode and a cathode among any one of the layer structures of a) to p) described above is indicated by a "repeating unit A".

q) anode/(repeating unit A)/charge generation layer/(repeating unit A)/cathode

The organic EL element having three or more light-emitting layers may be a layer structure of r) below where "(repeating unit A)/charge generation layer" is indicated by a "repeating unit B".

r)

```
anode/(repeating unit B)x/(repeating unit A)/cathode
```

In this structure, a symbol "x" is an integer of two or more, and (repeating unit B)x is a layered body in which the repeating unit B is layered x times.

The charge generation layer is a layer generating holes and electrons when electric field is applied thereto. The charge generation layer may be a thin film made of vanadium oxide, indium tin oxide (ITO), molybdenum oxide, or the like.

In the organic EL element, the anode is generally arranged near the substrate, but the cathode may also be arranged near the substrate.

In the organic EL element of the present embodiment, all of the layers arranged at the side from which light is extracted relative to the light-emitting layer are generally transparent in order to extract light from the light-emitting layer to the exterior.

The order or the number of the layers to be stacked and the thickness of each of the layers can be appropriately set in consideration of light-emitting efficiency or element life.

The material of and the forming method of each layer that constitutes the organic EL element are described more specifically below.

(Substrate)

A substrate that is not deformed while the organic EL element is manufactured is suitably used for the substrate. For example, glass, plastic, macromolecular films, silicon substrates, and layered bodies thereof are used. The substrate is commercially available or can be manufactured by a publicly known method.

(Anode)

The organic EL element with a structure in which light is extracted from the light-emitting layer through the anode employs an electrode having light transparency as the anode. A thin film of metallic oxides, metallic sulphides, metals, or the like that have high electric conductivity is applicable to such an electrode, and an electrode with high light transparency is suitably used. Specifically, a thin film made of, for example, indium oxide, zinc oxide, tin oxide, ITO, indium zinc oxide (IZO), gold, platinum, silver, and copper is used, and among them, a thin film made of ITO, IZO, and tin oxide is suitably used. The method for manufacturing the anode may be a vacuum deposition method, a sputtering method, an ion plating method, and a plating method. A transparent conductive film of an organic substance such as polyaniline or derivatives thereof and polythiophene or derivatives thereof may also be used for the anode.

For the anode, a material that reflects light may also be used. For the material, metals, metallic oxides, and metallic sulphides, all of which have a work function of 3.0 electron volts or more are preferred.

The film thickness of the anode can be appropriately selected in consideration of light transparency and electric conductivity and is, for example, 10 nanometers to 10 micrometers, preferably, 20 nanometers to 1 micrometer, and more preferably, 50 nanometers to 500 nanometers.

(Hole injection layer)

A hole injection material that constitutes the hole injection layer may be: oxides such as vanadium oxide, molybdenum oxide, ruthenium oxide, and aluminum oxide, and phenylamines, starburst-type amines, phthalocyanines, amorphous carbon, polyaniline, and polythiophene derivatives.

Examples of a method for forming a film of the hole injection layer include a method for forming a film from a solution containing the hole injection material. A solvent used for forming a film from the solution is not particularly limited so long as the solvent dissolves the hole injection material. The solvent may be: a chlorine based solvent such as chloroform, methylene chloride, and dichloroethane; an ether based solvent such as tetrahydrofuran; an aromatic hydrocarbon based solvent such as toluene and xylene; a ketone based solvent such as acetone and methyl ethyl ketone; an ester based solvent such as ethyl acetate, butyl acetate, and ethyl cellosolve acetate; and water.

The method for forming a film from the solution may be coating methods such as a nozzle printing method, a spin coating method, a casting method, a micro-gravure coating method, a gravure coating method, a bar coating method, a roll coating method, a wire bar coating method, a dip coating method, a spray coating method, a screen printing method, a flexo printing method, an offset printing method, and an ink-jet printing method. The nozzle printing method described above is suitably used in the present embodiment.

The optimal value for the film thickness of the hole injection layer varies depending on the material used. The film thickness is selected as appropriate so as to have moderate values of driving voltage and light-emitting efficiency and needs to be at least a thickness with which no pinhole is formed. When the thickness is too large, the driving voltage of the element may increase. Accordingly, the film thickness of the hole injection layer is, for example, 1 nanometer to 1 micrometer, preferably, 2 nanometers to 500 nanometers, and more preferably, 5 nanometers to 200 nanometers.

(Hole transport layer)

A hole transport material that constitutes the hole transport layer may be polyvinyl carbazole or derivatives thereof, polysilane or derivatives thereof, polysiloxane derivatives having an aromatic amine at the side chain or the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylene vinylene) or derivatives thereof.

Among them, The hole transport material may be: preferably, a polymer hole transport material such as polyvinyl carbazole or derivatives thereof, polysilane or derivatives thereof, polysiloxane derivatives having an aromatic amine compound group at the side chain or the main chain, polyaniline or derivatives thereof, polythiophene or derivatives thereof, polyarylamine or derivatives thereof, poly(p-phenylenevinylene) or derivatives thereof, or poly(2,5-thienylene vinylene) or derivatives thereof; and more preferably, polyvinyl carbazole or derivatives thereof, polysilane or derivatives thereof, and polysiloxane derivatives having an aromatic amine at the side chain or the main chain. When the hole transport material is a low molecular material, the material is preferably used by being dispersed in a macromolecular binder.

A method for forming a film of the hole transport layer is not particularly limited. However, A method for forming a film using a low molecular hole transport material may be a method for forming a film from a mixed solution of a macromolecular binder and the hole transport material, and A method for forming a film using a polymer hole transport material may be a method for forming a film from a solution comprising the hole transport material.

A solvent used for forming a film from the solution is not particularly limited so long as the solvent dissolves the hole transport material. The solvent mey be: a chlorine based solvent such as chloroform, methylene chloride, and dichloroethane; an ether based solvent such as tetrahydrofuran; an aromatic hydrocarbon based solvent such as toluene and xylene; a ketone based solvent such as acetone and methyl ethyl ketone; and an ester based solvent such as ethyl acetate, butyl acetate, and ethyl cellosolve acetate.

The method for forming a film from the solution may be coating methods similar to the method for forming a film of the hole injection layer described above. The nozzle printing method described above is suitably used in the present embodiment.

For the macromolecular binder to be mixed, a binder that does not extremely inhibit charge transportation is preferable, and a binder that has weak absorption of visible light is suitably used. Examples of the macromolecular binder include polycarbonate, polyacrylate, polymethyl acrylate, polymethyl methacrylate, polystyrene, polyvinyl chloride, and polysiloxane and the like.

The optimal value for the film thickness of the hole transport layer varies depending on the material used. The film thickness is set as appropriate so as to have moderate values of driving voltage and light-emitting efficiency and needs to be at least a thickness with which no pinhole is formed. When the thickness is too large, the driving voltage of the element may increase. Accordingly, the film thickness of the hole transport layer is, for example, 1 nanometer to 1 micrometer, preferably, 2 nanometers to 500 nanometers, and more preferably, 5 nanometers to 200 nanometers.

**EP 2 334 143 A1**

(Light-emitting layer)

The light-emitting layer is generally made of an organic substance that mainly emits any one of fluorescence and phosphorescence or both, or made of the organic substance and a dopant assisting the organic substance. The dopant is added in order to, for example, improve light-emitting efficiency and change a light-emitting wavelength. The organic substance may be a low molecular compound or a macromolecular compound. The light-emitting layer preferably comprises a macromolecular compound having a number average molecular weight of $10^3$ to $10^8$ in terms of polystyrene. Examples of a light-emitting material that constitutes the light-emitting layer include the following pigment materials, metal complex materials, macromolecular materials, and dopant materials.

(Pigment materials)

Examples of the pigment materials include cyclopendamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perynone derivatives, perylene derivatives, oligothiophene derivatives, oxadiazole dimmers, pyrazoline dimmers, quinacridone derivatives, and coumarin derivatives.

(Metal complex materials)

Examples of the metal complex materials include metal complexes having as a central metal, Al, Zn, Be, a rare-earth metal such as Tb, Eu, and Dy, or the like and having as a ligand, a structure of oxadiazole, thiadiazole, phenylpyridine, phenylbenzimidazole, quinoline, or the like, for example, metal complexes such as iridium complexes and platinum complexes that emit light from the triplet excited state, alumiquinolinol complexes, benzoquinolinole beryllium complexes, benzoxazolyl zinc complexes, benzothiazole zinc complexes, azomethyl zinc complexes, porphyrin zinc complexes, and europium complexes.

(Macromolecular materials)

The macromolecular materials may be polyparaphenylene vinylene derivatives, polythiophene derivatives, polyparaphenylene derivatives, polysilane derivatives, polyacetylene derivatives, polyfluorene derivatives, polyvinyl carbazole derivatives, and materials obtained by polymerizing the pigment materials or the metal complex light-emitting materials.

Among the light-emitting materials described above, The material that emits blue light include distyrylarylene derivatives, oxadiazole derivatives, and polymers of distyrylarylene derivatives and oxadiazole derivatives, polyvinyl carbazole derivatives, polyparaphenylene derivatives, and polyfluorene derivatives. Among them, polymer materials such as polyvinyl carbazole derivatives, polyparaphenylene derivatives, and polyfluorene derivatives are preferred.

The material that emits green light include quinacridone derivatives, coumarin derivatives, polymers of quinacridone derivatives and coumarin derivatives, polyparaphenylene vinylene derivatives, and polyfluorene derivatives. Among them, polymer materials such as polyparaphenylene vinylene derivatives and polyfluorene derivatives are preferred.

The material that emits red light include coumarin derivatives, thiophene ring compounds, polymers of coumarin derivatives and thiophene ring compounds, polyparaphenylene vinylene derivatives, polythiophene derivatives, and polyfluorene derivatives. Among them, polymer materials such as polyparaphenylene vinylene derivatives, polythiophene derivatives, and polyfluorene derivatives are preferred.

(Dopant materials)

Examples of the dopant materials include perylene derivatives, coumarin derivatives, rubrene derivatives, quinacridone derivatives, squarylium derivatives, porphyrin derivatives, styryl pigments, tetracene derivatives, pyrazolone derivatives, decacyclene, and phenoxazon. The thickness of such a light-emitting layer is generally about 2 nanometers to 200 nanometers.

(Method for forming film of light-emitting layer) An available method for forming a film of the light-emitting layer may be a method for applying a solution containing the light-emitting material, a vacuum deposition method, and a transfer method. A solvent used for forming a film from the solution may be a solvent similar to the solvent used for forming a film of the hole transport layer from the solution as described above.

The method for applying the solution containing a light-emitting material include: coating methods such as a spin coating method, a casting method, a micro-gravure coating method, a gravure coating method, a bar coating method, a roll coating method, a wire bar coating method, a dip coating method, a slit coating method, a capillary coating method,

11

a spray coating method, and a nozzle printing method; and an applying method such as a gravure printing method, a screen printing method, a flexo printing method, an offset printing method, a reverse printing method, and an ink-jet printing method. The nozzle printing method described above is suitably used in the present embodiment.

(Electron transport layer)

As an electron transport material that constitutes the electron transport layer, a publicly known material can be used. The material may be oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives of 8-hydroxyquinoline, polyquinoline or derivatives thereof, polyquinoxaline or derivatives thereof, and polyfluorene or derivatives thereof.

Among them, as the electron transport material, oxadiazole derivatives, benzoquinone or derivatives thereof, anthraquinone or derivatives thereof, metal complexes of 8-hydroxyquinoline or of derivatives of 8-hydroxyquinoline, polyquinoline or derivatives thereof, polyquinoxaline or derivatives thereof, and polyfluorene or derivatives thereof are preferred, and 2-(4-biphenylyl)-5-(4-t-butylphenyl)-1,3,4-oxadiazole, benzoquinone, anthraquinone, tris(8-quinolinol)aluminum, and polyquinoline are more preferred.

A method of forming a film of the electron transport layer is not particularly limited. However, A method for forming a film using a low molecular electron transport material may be a vacuum deposition method using the powder, and a method for forming a film from the solution or from the melted state. A method for forming a film using a macromolecular electron transport material may be a method for forming a film from the solution or from the melted state. When a film is formed from the solution or from the melted state, a macromolecular binder may also be used in combination. A method for forming a film of the electron transport layer from the solution may be a film forming method similar to the method for forming a film of the hole transport layer from the solution as described above. The nozzle printing method described above is suitably used in the present embodiment.

The optimal value for the film thickness of the electron transport layer varies depending on the material used. The film thickness is set as appropriate so as to have moderate values of driving voltage and light-emitting efficiency and needs to be at least a thickness with which no pinhole is formed. When the thickness is too large, the driving voltage of the element may increase. Accordingly, the film thickness of the electron transport layer is, for example, 1 nanometer to 1 micrometer, preferably, 2 nanometers to 500 nanometers, and more preferably, 5 nanometers to 200 nanometers.

(Electron injection layer)

For a material that constitutes the electron injection layer, an optimal material is appropriately selected depending on the type of the light-emitting layer. The material may be: alkali metals; alkaline-earth metals; alloys that contain one or more types of alkali metals and alkaline-earth metals; oxides, halides, and carbonates of alkali metals or alkaline-earth metals; or a mixture of these substances. Examples of the alkali metals, or the oxides, halides, and carbonates of alkali metals include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals or the oxides, halides, and carbonates of alkaline-earth metals include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may also be a layered body in which two or more layers are stacked, and examples thereof include LiF/Ca. The electron injection layer is formed by a vapor deposition method, a sputtering method, a printing method, or the like. The film thickness of the electron injection layer is preferably about 1 nanometer to 1 micrometer.

(Cathode)

A material that has a small work function, facilitates electron injection into the light-emitting layer, and has high electric conductivity is preferred as a material for the cathode. In the organic EL element in which light is extracted through the anode, a material having high reflectance of visible light is preferred as the material for the cathode because the cathode reflects the light output from the light-emitting layer to the anode. For example, alkali metals, alkaline-earth metals, transition metals, and the 13th-group metals in the periodic table can be used for the cathode. Examples of the material for the cathode include: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more types of the metals; alloys of one or more types of the metals and one or more types of gold, silver, platinum, copper, manganese, titanium, cobalt, nickel, tungsten, and tin; or graphite or graphite interlayer compounds. Examples of the alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. For the cathode, a transparent conductive electrode made of a conductive metal oxide, a conductive organic substance, or the like can be used. Specific examples of the conductive metal oxide may include indium oxide, zinc oxide, tin oxide, ITO, and IZO. Specific examples of the conductive organic substance may include polyaniline or derivatives thereof and polythiophene or derivatives thereof. The cathode may be a layered body in which two or more layers are stacked. The electron injection layer may also be used as the cathode.

The film thickness of the cathode is appropriately set in consideration of electric conductivity and durability and is, for example, 10 nanometers to 10 micrometers, preferably, 20 nanometers to 1 micrometer, and more preferably, 50 nanometers to 500 nanometers.

A method for manufacturing the cathode may be a vacuum deposition method, a sputtering method, a lamination method by which a metal thin film is thermocompression bonded.

A substrate for patterned application of another embodiment of the present invention comprises absorption portions that have absorptivity relative to the anisole at one side and the other side of the non-patterning area relative to the patterning area where the partitions are provided in their longitudinal direction of the partitions. A solvent that dissolves a material for forming a predetermined organic layer is not limited to anisole. However, when the absorption portions have absorptivity relative to the anisole, the portions also have absorptivity relative to an ink generally used.

In the substrate for patterned application of the present embodiment, the lyophilic portions as the ink retaining portions of the embodiment described above are replaced with the absorption portions, the components except for the absorption portions are similar to those of the embodiment described above, and thus, the description is omitted. The positions where the absorption portions are provided are similar to the positions where the lyophilic portions are provided, and therefore, the constituent member of the absorption portions is alone described.

The absorption portions comprise a member that has anisole absorptivity (that can absorb anisole) and preferably comprise a member that has high absorptivity.

The absorption portions preferably comprise, for example, silicon oxide, silicon nitride, a macromolecular compound, or a mixture thereof. Particularly, the absorption portions are preferably porous.

The macromolecular compound may be polyacrylate materials such as sodium polyacrylate, polyvinyl ether materials such as polyvinyl methyl ether, polyvinyl alcohol materials, vinyl acetate-acrylate materials, and poly-N-vinyl-lacetamide materials.

The silicon oxide may be SiO, $Si_2O_3$, and $SiO_2$, and the silicon nitride may be SiN and $Si_3N_4$.

An absorption portion made of porous silicon oxide can be formed by subjecting a surfactant, tetraethoxysilane, and the like to a sol-gel reaction and by firing the resultant substance to remove the surfactant. A commercial sheet made of a porous macromolecular compound can be used for an absorption portion made of a porous macromolecular compound.

Each of the absorption portions is preferably formed on a masking tape. In other words, the substrate 11 for patterned application further comprises a masking tape interposed between the substrate body 12 and the absorption portion. The absorption portion is provided in contact with one surface of the masking tape. A binder is provided at the other surface of the masking tape. Therefore, the masking tape can be attached to the insulating wall 17 with the binder and can be peeled from the insulating wall 17 after the attachment.

The absorption portion can be formed on the surface of the masking tape by, for example, the method as described above. When the absorption portion is formed on the masking tape in such a manner, the absorption portion can be easily attached via the masking tape and can be easily peeled off to improve the workability.

For example, the ink is applied in a certain continuous line as described above to form the organic light-emitting layer using the nozzle printing apparatus by a coating method, and thus, the ink is applied also on the absorption portion. The ink applied to the absorption portion is absorbed in the absorption portion and is retained in the absorption portion. Accordingly, the ink applied to the area where the patterning area is not provided can be prevented from flowing into the position between the partitions 15 that is the patterning area. Moreover, the ink can be prevented from being mixed with the ink applied to the neighboring lines. Therefore, the film thickness at both ends of the patterning area in the longitudinal direction can be prevented from being thicker than the film thickness at the center when the supplied ink is dried. Thus, an organic light-emitting layer having a uniform film thickness can be formed in the patterning area, and the color mixing described above can also be prevented.

Moreover, in another embodiment of the present invention, the absorption portion preferably has a contact angle to anisole of less than 30 degrees. Thus, the absorption portion that has absorptivity and lyophilicity is provided to retain the ink at the absorption portion. This is because, for example, the ink applied to the absorption portion while an organic light-emitting layer is formed using the nozzle printing apparatus by a coating method is absorbed in the absorption portion and wet and spread over the absorption portion. Accordingly, the ink applied to the area where the patterning area is not provided can be prevented from flowing into the position between the partitions 15 that is the patterning area. Moreover, the ink can be prevented from being mixed with the ink applied to the neighboring lines. Therefore, the film thickness at both ends of the patterning area in the longitudinal direction can be prevented from being thicker than the film thickness at the center when the supplied ink is dried. Thus, an organic light-emitting layer having a uniform film thickness can be formed in the patterning area, and the color mixing can also be prevented.

The substrate for patterned application as a passive matrix substrate is described in the description of the embodiments described above. However, the substrate for patterned application is not limited to the passive matrix substrate, and an active matrix substrate is also applicable when the substrate body comprises a predetermined electronic component such as a transistor.

The organic EL element as described above can be suitably used for a curved or flat illumination device, a planar light source used for, for example, a light source of a scanner, and a display device.

The display device conprising the organic EL element may be a segment display device and a dot-matrix display device. The dot-matrix display device may be an active matrix display device and a passive matrix display device. In the active matrix display device and the passive matrix display device, the organic EL element is used as a light-emitting element constituting each pixel. The organic EL element is used as a light-emitting element constituting each segment in the segment display device and is used as a backlight in a liquid crystal display device.

The substrate for patterned application as a substrate for forming the organic EL element is described in the descriptions of the embodiments described above. However, the substrate for patterned application is not limited to the substrate for the organic EL element and is applicable to a substrate for color filters.

A substrate for patterned application for color filters and a color filter manufactured by using the substrate are described below.

A substrate 21 for patterned application for color filters has a structure of the substrate for patterned application of the embodiment described above and illustrated in FIG. 1 from which the electrodes 13 are removed and in which the insulating film 14 is replaced with a light-shielding film 24. Identical reference numerals are given to the corresponding components, and overlapping descriptions are omitted.

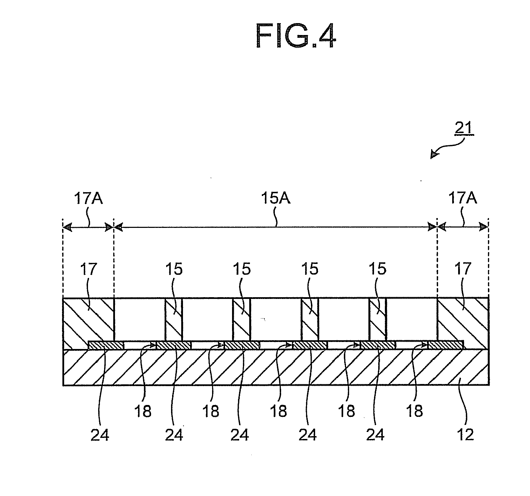

FIG. 4 is a sectional schematic of the substrate 21 for patterned application for color filters. The substrate 11 for patterned application for color filters comprises the light-shielding film 24 instead of the insulating film 14. The light-shielding film 24 functions as a so-called black matrix. The plane schematic view of the substrate 21 for patterned application for color filters is similar to FIG. 1, and FIG. 4 corresponds to the sectional schematic view cut along a sectional line VI-VI of FIG. 1.

The light-shielding film 24 is formed on the substrate body 12 in a grid. The light-shielding film 24 does not need to have insulation properties so long as the film has a property to shield light.

The light-shielding film 24 is made of inorganic substances or organic substances. The inorganic substances constituting the light-shielding film 24 may be metals such as chromium and nickel alloys. For example, the light-shielding film 24 is formed by evaporating chromium onto one surface of the substrate body 12 and by patterning it by a photolithography method. The organic substances constituting the light-shielding film 24 may be resins containing black pigment. For example, the light-shielding film 24 is formed by applying an application liquid containing black pigment dispersed in a photosensitive resin to the substrate body 12 and by exposing the predetermined portion to light to develop the portion.

Subsequently, the partitions 15 and the insulating wall 17 are formed. The partitions 15 and the insulating wall 17 can be formed in a manner similar to the method described above. The partitions 15 and the insulating wall 17 preferably have light shielding properties and are preferably formed by using the application liquid containing black pigment dispersed in a photosensitive resin as described above.

The lyophilic portion 16 or the absorption portion is similar to that as described above, and thus, overlapping descriptions are omitted.

A method for forming color filters using the substrate for patterned application is described below. A color filter can be manufactured by forming a color filter film at a position between the partitions 15 on the substrate 21 for patterned application. The color filter film can be formed in a manner similar to the method for forming the organic light-emitting layer described above in which the application liquid used for forming the organic light-emitting layer described above is replaced with an application liquid for a color filter film.

The application liquid for a color filter film include an ink including a predetermined pigment dispersed in a dispersion medium. The predetermined pigment means each pigment of red, green, and blue when three color filter films of red, green, and blue are formed at an interval of two lines. The dispersion medium may be a photosensitive resin.

The color filter film can be formed by applying the ink by the nozzle printing apparatus described above and by irradiating the ink with light to cure it.

The ink is applied in a certain continuous line as described above to form the color filter film using the nozzle printing apparatus by a coating method, and thus, the ink is applied also on the lyophilic portion 16 or the absorption portion. The ink applied to the lyophilic portion 16 or the absorption portion wets and spreads over the lyophilic portion 16 or is absorbed in the absorption portion, and thus is retained in the lyophilic portion 16 or the absorption portion. Accordingly, the ink applied to the area where the patterning area 15A is not provided can be prevented from flowing into the position between the partitions 15 that is the patterning area 15A. Moreover, the ink can be prevented from being mixed with the ink applied to the neighboring lines. Therefore, the film thickness at both ends of the patterning area 15A in the longitudinal direction can be prevented from being thicker than the film thickness at the center when the color filter film is formed. Thus, a color filter film having a uniform film thickness can be formed in the patterning area 15A, and the color mixing can also be prevented.

Such a color filter can be suitably used as a color filter for a liquid crystal display device. The display device comprising the organic EL element described above can be a display device having high color purity by providing the color filter.

Although the light-shielding film 24 is provided in the present embodiment, the substrate for patterned application may not comprise the light-shielding film 24.

EXPLANATIONS OF LETTERS OR NUMERALS

1, 11, 21 Substrate (for patterned application)
2, 13 Electrode
3, 14 Insulating film
4, 18 Opening portion
5, 15 Partition
15A Patterning area
12 Substrate body
16 Lyophilic portion
17 Insulating wall
17A Non-patterning area
18 Opening
24 Light-shielding film
100 Ink

**Claims**

1. A substrate for patterned application comprising:

   a substrate body having a patterning area and a non-patterning area surrounding the patterning area;
   a plurality of partitions provided in stripes in the patterning area of the substrate body; and
   an ink retaining portion provided in the non-patterning area on one side and on the other side of the partitions in their longitudinal direction and being capable of retaining an applied liquid ink.

2. The substrate according to claim 1 for patterned application, wherein the ink retaining portion is a lyophilic portion having such a lyophilicity that a contact angle to anisole is less than 30 degrees.

3. The substrate according to claim 2 for patterned application,
   wherein the ink retaining portion comprises an inorganic substance.

4. The substrate according to claim 3 for patterned application,
   wherein the lyophilic portion comprises silicon oxide, silicon nitride, or a mixture thereof.

5. The substrate according to claim 2 for patterned application, further comprising a masking tape interposed between the substrate body and the lyophilic portion,
   wherein the lyophilic portion is provided in contact with the masking tape.

6. The substrate according to claim 1 for patterned application,
   wherein the ink retaining portion is an absorption portion that has anisole absorptivity.

7. The substrate according to claim 6 for patterned application,
   wherein the absorption portion is porous.

8. The substrate according to claim 7 for patterned application,
   wherein the absorption portion comprises silicon oxide, silicon nitride, a macromolecular compound, or a mixture thereof.

9. The substrate according to claim 6 for patterned application, further comprising a masking tape interposed between the substrate body and the absorption portion,
wherein the absorption portion is provided in contact with the masking tape.

10. An organic electroluminescent element manufactured by using the substrate according to claim 1 for patterned application.

11. A display device comprising the organic electroluminescent element according to claim 10.

12. A color filter manufactured by using the substrate according to claim 1 for patterned application.

# FIG.1

# FIG.2

# FIG.3

# FIG.4

# FIG.5

# FIG.6

# FIG.7

# FIG.8

**INTERNATIONAL SEARCH REPORT**

| International application No. |
|---|
| PCT/JP2009/065857 |

A.  CLASSIFICATION OF SUBJECT MATTER
*H05B33/02*(2006.01)i, *G02B5/20*(2006.01)i, *H01L51/50*(2006.01)i, *H05B33/12*
(2006.01)i, *H05B33/22*(2006.01)i

According to International Patent Classification (IPC) or to both national classification and IPC

B.  FIELDS SEARCHED

Minimum documentation searched (classification system followed by classification symbols)
H05B33/02, G02B5/20, H01L51/50, H05B33/12, H05B33/22

Documentation searched other than minimum documentation to the extent that such documents are included in the fields searched
Jitsuyo Shinan Koho          1922-1996   Jitsuyo Shinan Toroku Koho    1996-2009
Kokai Jitsuyo Shinan Koho    1971-2009   Toroku Jitsuyo Shinan Koho    1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2008-678 A  (Dainippon Screen Mfg. Co., Ltd.),<br>10 January 2008 (10.01.2008),<br>paragraphs [0026], [0029] to [0042], [0054], [0059], [0060], [0069] to [0096], [0103]; fig. 2, 3, 11, 12, 16 to 21<br>(Family: none) | 1,6-12<br>2-5 |
| Y | JP 2008-91071 A  (Seiko Epson Corp.),<br>17 April 2008 (17.04.2008),<br>paragraphs [0035] to [0038]; fig. 4<br>(Family: none) | 2-5 |

☐   Further documents are listed in the continuation of Box C.        ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>09 December, 2009 (09.12.09) | Date of mailing of the international search report<br>22 December, 2009 (22.12.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
| --- |
| PCT/JP2009/065857 |

---

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
    because they relate to subject matter not required to be searched by this Authority, namely:

2. ☐ Claims Nos.:
    because they relate to parts of the international application that do not comply with the prescribed requirements to such an extent that no meaningful international search can be carried out, specifically:

3. ☐ Claims Nos.:
    because they are dependent claims and are not drafted in accordance with the second and third sentences of Rule 6.4(a).

---

**Box No. III      Observations where unity of invention is lacking (Continuation of item 3 of first sheet)**

This International Searching Authority found multiple inventions in this international application, as follows:

    Since document JP 2008-678 A (Dainippon Screen Mfg. Co., Ltd.) discloses a substrate for pattern coating, an organic electroluminescent element and a display device having the technical features specifying the inventions of claims 1, 6-11, the inventions of claims 1, 6-11 are not novel over the invention disclosed in the document. Consequently, the inventions of claims 1, 6-11 do not have a special technical feature.
    Since there is no technical relationship among these inventions involving one or more of the same or corresponding special technical features, these inventions are not considered so linked as to form a single general inventive concept.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002075640 A